(19) Europäisches Patentamt / European Patent Office / Office européen des brevets

(11) **EP 3 182 176 B1**

(12) **FASCICULE DE BREVET EUROPEEN**

(45) Date de publication et mention de la délivrance du brevet:
**05.01.2022 Bulletin 2022/01**

(51) Int Cl.:
***G01V 11/00*** *(2006.01)*

(21) Numéro de dépôt: **16306534.5**

(22) Date de dépôt: **22.11.2016**

(54) **PROCEDE D'EXPLOITATION DES HYDROCARBURES D'UN BASSIN SEDIMENTAIRE, AU MOYEN D'UNE SIMULATION DE BASSIN, AVEC PRISE EN COMPTE DES EFFETS GEOMACANIQUES**

VERFAHREN ZUR KOHLENWASSERSTOFFGEWINNUNG IN EINEM SEDIMENTBECKEN MITHILFE EINER SIMULATION DES BECKENS UNTER BERÜCKSICHTIGUNG DER GEOMECHANISCHEN EFFEKTE

METHOD FOR MINING HYDROCARBONS FROM A SEDIMENTARY BASIN, USING A BASIN SIMULATION, TAKING GEOMECHANICAL EFFECTS INTO ACCOUNT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.12.2015 FR 1562666**

(43) Date de publication de la demande:
**21.06.2017 Bulletin 2017/25**

(73) Titulaires:
• **IFP Energies nouvelles**
  **92500 Rueil-Malmaison (FR)**
• **TOTAL SE**
  **92400 Courbevoie (FR)**

(72) Inventeurs:
• **GUY, Nicolas**
  **75003 PARIS (FR)**
• **COLOMBO, Daniele**
  **92140 CLAMART (FR)**
• **FREY, Jeremy**
  **78110 LE VESINET (FR)**
• **VINCKE, Olivier**
  **95110 SANNOIS (FR)**
• **GOUT, Claude**
  **92400 COURBEVOIE (FR)**

(74) Mandataire: **IFP Energies nouvelles**
**Département Propriété Industrielle**
**Rond Point de l'échangeur de Solaize**
**BP3**
**69360 Solaize (FR)**

(56) Documents cités:
**US-A1- 2002 120 429     US-A1- 2009 265 152**
**US-A1- 2011 141 851**

**Description**

La présente invention concerne le domaine de l'exploration et de l'exploitation des gisements pétroliers ou de sites de stockage géologique de gaz.

Plus particulièrement, la présente invention concerne la modélisation de bassin, appliquée notamment à l'évaluation du potentiel pétrolier d'un bassin sédimentaire ayant subi une histoire géologique complexe.

L'exploration pétrolière consiste à rechercher des gisements d'hydrocarbures au sein d'un bassin sédimentaire. La compréhension des principes de la genèse des hydrocarbures et leurs liens avec l'histoire géologique du sous-sol, a permis la mise au point de méthodes d'évaluation du potentiel pétrolier d'un bassin sédimentaire. La démarche générale de l'évaluation du potentiel pétrolier d'un bassin sédimentaire comporte des allers-retours entre une prédiction du potentiel pétrolier du bassin sédimentaire, réalisée à partir d'informations disponibles concernant le bassin étudié (affleurements, campagnes sismiques, forages par exemple), et des forages d'exploration dans les différentes zones présentant le meilleur potentiel, afin de confirmer ou infirmer le potentiel prédit préalablement, et d'acquérir de nouvelles données pour alimenter de nouvelles études plus précises.

L'exploitation pétrolière d'un gisement consiste, à partir des informations récoltées lors de la phase d'exploration pétrolière, à sélectionner les zones du gisement présentant le meilleur potentiel pétrolier, à définir des schémas d'exploitation optimaux pour ces zones (par exemple à l'aide d'une simulation de réservoir, afin de définir les nombre et positions des puits d'exploitation permettant une récupération d'hydrocarbures optimale), à forer des puits d'exploitation et, de façon générale, à mettre en place les infrastructures de production nécessaires au développement du gisement.

Un bassin sédimentaire résulte du dépôt, au cours des temps géologiques, de sédiments au sein d'une dépression de la croûte terrestre. Ces sédiments, meubles et riches en eau vont être soumis, lors de leur enfouissement progressif dans le bassin, à des conditions de pression et de température qui vont les transformer en roches sédimentaires compactes, dites couches géologiques.

L'architecture au temps actuel d'un bassin sédimentaire résulte notamment d'une déformation mécanique du sous-sol au cours des temps géologiques. Cette déformation comporte a minima une compaction des couches géologiques, due à l'enfouissement progressif de ces couches au sein du bassin, sous l'effet de l'arrivée de nouveaux sédiments. Mais un bassin sédimentaire est également le plus souvent soumis à des mouvements tectoniques de grande ampleur, générant par exemple des plissements des couches géologiques, ou encore des failles venant créer une rupture dans les couches géologiques.

La nature des hydrocarbures présents dans un bassin sédimentaire quant à elle résulte notamment du type de matière organique présente dans les sédiments s'étant déposés, mais aussi des conditions de pression et de température auxquelles est soumis le bassin au cours des temps géologiques.

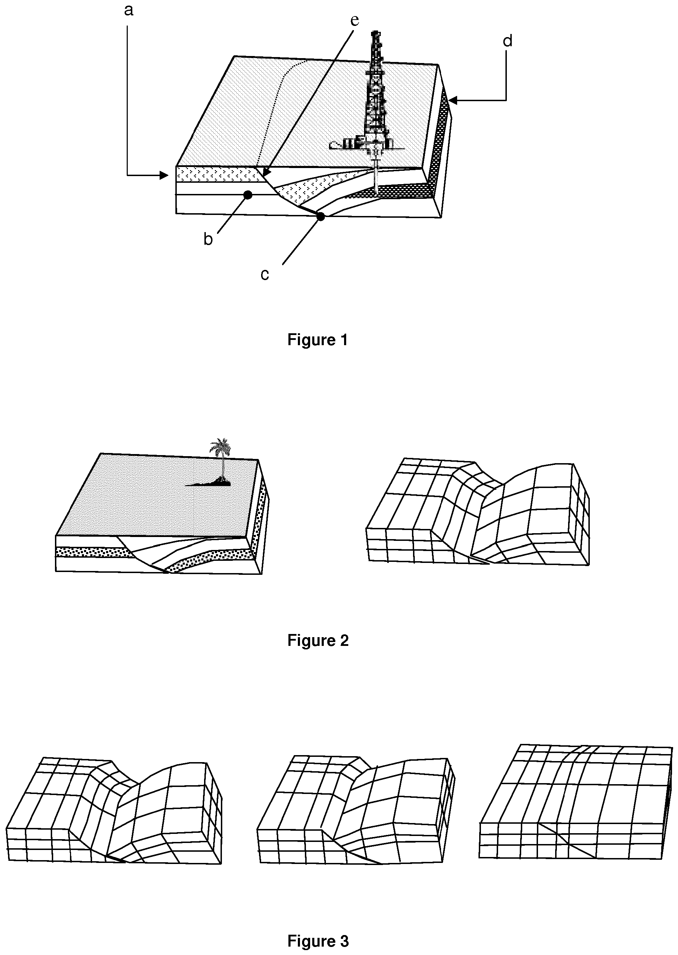

La Figure 1 montre une représentation schématique d'un bassin sédimentaire, comportant plusieurs couches géologiques (a,c), délimitées par des interfaces sédimentaires (b) traversées par une faille (e), et une accumulation d'hydrocarbures (d) dans une des couches géologiques du bassin considéré (c).

La formation d'un bassin sédimentaire implique donc un grand nombre de processus physiques et chimiques complexes, pouvant qui plus est interagir. Face à cette complexité, la prédiction du potentiel pétrolier d'un bassin sédimentaire requiert de disposer d'outils informatiques permettant de simuler, de la façon la plus réaliste possible, les phénomènes physiques et chimiques impliqués lors de la formation du bassin étudié.

Ce type de reconstitution de l'histoire de la formation d'un bassin sédimentaire, appelée aussi modélisation de bassin, est le plus souvent réalisée à l'aide d'une famille d'outils informatiques permettant de simuler en une, deux ou trois dimensions, les processus sédimentaires, tectoniques, thermiques, hydrodynamiques et de chimie organique et inorganique qui interviennent lors de la formation d'un bassin pétrolier.

La modélisation de bassin comporte classiquement trois étapes :

- une étape de géo-modélisation, qui consiste à construire une représentation maillée du bassin étudié. Cette représentation maillée est le plus souvent structurée en couches, c'est-à-dire qu'un groupe de mailles est affecté à chaque couche géologique du bassin modélisé. Puis, chaque maille de cette représentation maillée est remplie par une ou plusieurs propriétés pétrophysiques, telles que la porosité, le faciès (argile, sable, etc) ou encore la teneur en matière organique. La construction de ce modèle se base sur des données acquises au cours de campagnes sismiques, de mesures dans des puits, de carottages, etc.

- une étape de reconstruction structurale de l'architecture du bassin : il s'agit de reconstruire les architectures passées du bassin. Pour ce faire, on déforme la représentation maillée construite à l'étape précédente afin de représenter l'évolution anti-chronologique de l'architecture du sous-sol au cours des temps géologiques, et ce pour différentes périodes temporelles appelées aussi pas de temps.

- une étape de simulation de bassin : il s'agit d'une simulation numérique d'une sélection de phénomènes physiques et chimiques se déroulant au cours de l'évolution du bassin et contribuant à la formation des pièges pétroliers. Cette simulation de bassin s'effectue pas de temps par pas de temps, et s'appuie pour chaque pas de temps sur les représentations maillées construites pour chaque pas de temps à l'étape précédente. En particulier, une simulation de bassin fournit une cartographie prédictive du sous-sol, indiquant l'emplacement probable des gisements, ainsi que la teneur, la nature et la pression des hydrocarbures qui y sont piégés.

En fournissant des informations quantitatives et fiables, cette démarche intégrée de modélisation de bassin permet d'augmenter le taux de succès lors d'un forage d'un puits d'exploration.

De façon générale, un bassin sédimentaire peut être soumis au cours de son histoire à des contraintes mécaniques caractérisées par des composantes dans les trois dimensions de l'espace, ces contraintes pouvant être locales ou régionales, et variables au cours du temps. Ces contraintes mécaniques sont d'une part induites par les dépôts de sédiments eux-mêmes. Dans ce cas, les contraintes mécaniques comportent une composante verticale, liée au poids des sédiments sur les couches déjà déposées, mais comportent le plus souvent également une composante horizontale, les dépôts sédimentaires n'étant généralement pas invariants latéralement. D'autre part, un bassin sédimentaire subit, tout au long de sa formation, des contraintes mécaniques induites par des mouvements tectoniques liés à la géodynamique terrestre, tels que des mouvements en extension (provoquant l'ouverture du bassin avec par exemple la formation de rift) ou encore des mouvements en compression (provoquant des plissements, des chevauchements, des fractures au sein du bassin etc). Ces mouvements tectoniques induisent le plus souvent des variations de contraintes mécaniques dans les trois dimensions de l'espace. A noter qu'une couche déjà déposée va subir des variations de contraintes induites par les mouvements tectoniques auxquels est soumis un bassin sédimentaire tout au long de sa formation.

Très classiquement, comme décrit par exemple le document (Schneider F., 2003), les logiciels de simulation de bassin font une hypothèse de variations uniquement verticales des contraintes mécaniques affectant un bassin sédimentaire. Plus précisément, les logiciels de simulation de bassin ne prennent en compte que la composante verticale des variations de contraintes mécaniques induites par le poids des dépôts sédimentaires successifs au cours du temps. On parle alors de simulation 1D des effets mécaniques.

La non prise en compte des variations tridimensionnelles des contraintes mécaniques peut avoir de lourdes conséquences dans l'évaluation du potentiel pétrolier d'un bassin sédimentaire. En effet, les contraintes mécaniques horizontales peuvent par exemple engendrer des fractures ou des plissements dans les couches géologiques du bassin, ce qui peut fortement modifier les caractéristiques des gisements pétroliers et des roches couvertures de ces gisements, et par voie de conséquence les chemins préférentiels d'écoulement, les niveaux de pression dans le bassin, la localisation des pièges à hydrocarbures, etc.

Une prise en compte en trois dimensions des variations de contraintes mécaniques subies par un bassin sédimentaire au cours de sa genèse apparaît donc importante pour une prédiction réaliste du potentiel pétrolier dudit bassin, et ce d'autant plus lorsque ce bassin a subi une histoire géologique complexe.

## État de la technique

Les documents suivants seront cités au cours de la description :

Nayroles, B., G. Touzot and P. Villon. 1991. The diffuse approximation. C. R. Acad. Sci., Paris, série II. 313: 293-296.
Scheichl, R., Masson, R., Wendebourg, J., Decoupling and Block Preconditioning for Sedimentary Basin Simulations, Computational Geosciences 7(4), pp. 295-318, 2003.
Schneider F., Modelling multi-phase flow of petroleum at the sedimentary basin scale. Journal of Geochemical exploration 78-79 (2003) 693-696.
Schneider, F., S. Wolf, I. Faille, D. Pot, A 3D Basin Model for Hydrocarbon Potential Evaluation : Application to Congo Offshore , Oil & Gas Science and Technology - Rev. IFP, Vol. 55 (2000), No. 1, pp. 3-13.
Steckler, M.S., and A.B. Watts, Subsidence of the Atlantic-type continental margin off New York, Earth Planet. Sci. Lett., 41, 1-13, 1978.
Zoback ,M. D., Reservoir Geomechanics, 2010.
Zienkiewicz, O.C., RL Taylor et JZ Zhu, The Finite Element Method: Its Basis and Fundamentals (seventh ed.), 2013.

On connait les documents suivants :

- US 2011/141851 A1, qui concerne un système et une méthode de prédiction intégrée de la qualité des réservoirs et des joints d'étanchéité ;
- US 2009/265152 A1, qui concerne une méthode de recherche d'hydrocarbures dans un bassin géologiquement complexe, au moyen d'une modélisation de bassin ;
- US 2002/120429 A1, qui concerne une méthode de modélisation des domaines multidimensionnels.

On connaît le brevet US 8271243 B2 qui divulgue une coopération entre une simulation de bassin et une simulation géomécanique, en vue d'une prise en compte des effets géomécaniques tridimensionnels au cours de la modélisation de bassin.

La modélisation géomécanique, appliquée au domaine de l'évaluation du potentiel pétrolier d'un bassin sédimentaire, utilise classiquement des historiques de pression, de température et de saturation, des quantités de sédiments déposés ou érodés, d'éventuelles contraintes tectoniques, ainsi que des lois de comportement associées aux différentes lithologies du domaine modélisé, et ce afin de décrire le comportement géomécanique d'un bassin au cours des temps géologiques.

La mise en œuvre d'une modélisation géomécanique comporte généralement deux phases :

- une phase de géo-modélisation, qui consiste en la construction d'un maillage du bassin sédimentaire à étudier. Comme pour la simulation de bassin, cette représentation maillée est le plus souvent structurée en couches, c'est-à-dire qu'un groupe de mailles est affecté à chaque couche géologique du bassin modélisé. Puis, chaque maille de cette représentation maillée est associée par exemple à une loi de comportement géomécanique, une porosité, une pression, une contrainte ou encore une densité. La construction de ce modèle se base sur des données acquises au cours de campagnes sismiques, de mesures dans des puits, de carottages, etc. Pour des raisons de résolution numérique des équations impliquées en simulation de bassin et en simulation géomécanique, une représentation maillée adaptée à une simulation de bassin peut être différente d'une représentation maillée adaptée à une simulation géomécanique.

- une étape de simulation numérique géomécanique, qui permet de calculer l'évolution au cours du temps de la distribution des contraintes dans chacune des mailles de la représentation maillée, ainsi que les déformations résultantes. Ce type de technique est utilisé dans le domaine de l'industrie pétrolière, mais il est aussi utilisé par exemple dans le domaine de la géotechnique. Les simulateurs géomécaniques utilisent pour ce faire une représentation maillée telle que décrite précédemment, et vont résoudre de manière discrète l'équation de la conservation de la quantité de mouvement par la méthode des éléments finis. Cette technique permet notamment de prédire les variations de contraintes dans les trois dimensions de l'espace.

Le brevet US 8271243 B2 décrit un procédé basé sur une coopération entre une simulation de bassin et une simulation géomécanique. Dans l'approche décrite dans le brevet US 8271243 B2, on ne détermine les variations de contraintes géomécaniques tridimensionnelles auxquelles est soumise une couche donnée qu'une seule fois, uniquement au cours de son dépôt. Autrement dit, dans l'approche décrite dans le brevet US 8271243 B2, on néglige les effets géomécaniques tridimensionnels résultant du dépôt de couches ultérieures ou de mouvements tectoniques affectant le bassin après le dépôt de cette couche.

Une telle mise en œuvre de la prise en compte de l'évolution des contraintes géomécaniques tridimensionnelles au fur et à mesure de la mise en place d'un bassin sédimentaire est donc insatisfaisante, dès que ce bassin est caractérisé par des dépôts variables latéralement (induisant des variations de contraintes horizontales, et non pas uniquement verticales) et est soumis à des contraintes tectoniques (comprenant généralement une composante horizontale non nulle). Il peut notamment en résulter une erreur dans l'estimation finale des pressions de pores et des saturations en fluide dans chacune des mailles de la représentation maillée représentative du temps actuel et obtenue après la mise en œuvre du procédé selon le brevet US 8271243 B2. Or une connaissance précise de ces informations est cruciale pour l'évaluation pétrolière d'un bassin sédimentaire (par exemple la décision d'exploiter un bassin sédimentaire donné se base notamment sur la connaissance de la saturation en hydrocarbures dans ce bassin) et son exploitation (par exemple la décision d'utiliser tel ou tel schéma d'exploitation pétrolière se base sur la connaissance des pressions de pores au sein de ce bassin).

L'objet de la présente invention concerne la prise en compte dans une simulation de bassin des effets géomécaniques tridimensionnels auxquels est soumise une couche lors de son dépôt, mais aussi des effets géomécaniques tridimensionnels engendrés par le dépôt ou l'érosion de cette couche sur les couches sous-jacentes, déjà déposées. De plus, l'invention peut permettre la prise en compte de contraintes tectoniques. Ainsi, la présente invention vise à une meilleure prédiction des quantités prédites par une simulation de bassin, notamment les pressions de pores et les saturations en fluide.

**Le procédé selon l'invention**

Ainsi, la présente invention concerne un procédé d'exploitation d'un bassin sédimentaire comportant des hydrocarbures, comprenant une reconstitution de la formation dudit bassin, ladite formation comprenant au moins le dépôt de deux couches sédimentaires, ladite reconstitution étant réalisée au moyen d'un simulateur de bassin et d'un simulateur géomécanique coopérant entre eux, au moyen de mesures de propriétés relatives audit bassin et de représentations maillées représentatives dudit bassin au moment du dépôt de chacune desdites couches sédimentaires. A partir desdites mesures et d'une reconstitution de ladite formation de la première desdites couches, ladite reconstitution pour au moins une desdites couches sus-jacentes à ladite première couche est mise en œuvre selon au moins les étapes suivantes :

A. au moyen dudit simulateur de bassin, on réalise une simulation de bassin conjointe de ladite couche et d'au moins une couche sous-jacente à ladite couche, et on détermine un premier jeu de paramètres ;

B. à partir d'au moins une partie dudit premier jeu desdits paramètres et dudit simulateur géomécanique, on réalise une simulation géomécanique conjointe de ladite couche et d'au moins une couche sous-jacente à ladite couche, et on détermine un deuxième jeu de paramètres ;

C. on mesure un écart entre au moins une partie desdits paramètres dudit premier jeu et au moins une partie desdits paramètres dudit deuxième jeu, et on réitère les étapes A) à C) en appliquant une correction à ladite simulation de bassin si ledit écart est supérieur à un seuil prédéfini ;

Puis, au moyen de ladite reconstitution réalisée pour lesdites couches, on sélectionne au moins une zone dudit bassin comportant lesdits hydrocarbures, et on exploite ledit bassin en fonction de ladite zone sélectionnée.

Selon un mode de mise en œuvre de l'invention, ladite reconstitution relative à ladite première couche peut être réalisée selon au moins les étapes suivantes :

i. au moyen dudit simulateur de bassin, on réalise une simulation de bassin relative à ladite première couche, et on détermine un premier jeu de paramètres ;

ii. à partir d'au moins une partie dudit premier jeu desdits paramètres et dudit simulateur géomécanique, on réalise une simulation relative à ladite première couche, et on détermine un deuxième jeu de paramètres ;

iii. on mesure un écart entre au moins une partie desdits paramètres dudit premier jeu et au moins une partie desdits paramètres dudit deuxième jeu, et on réitère les étapes i) à iii) en appliquant une correction à ladite simulation de bassin si ledit écart est supérieur à un seuil prédéfini.

Selon un mode de mise en œuvre de l'invention, ledit premier jeu de paramètres peut comprendre au moins la porosité et la pression en chacune des mailles de ladite représentation maillée.

Selon un mode de mise en œuvre de l'invention, ledit deuxième jeu de paramètres peut comprendre au moins la porosité en chacune des mailles de ladite représentation maillée.

Préférentiellement, ledit écart peut être fondé sur une mesure de la différence entre ladite porosité issue dudit premier jeu de et ladite porosité issue dudit deuxième jeu.

Avantageusement, ledit écart peut être un écart absolu $MES^{abs}$ défini selon une formule du type :

$$MES^{abs} = max_{n \in N}\left(\left|\varphi_n^g - \varphi_n^b\right|\right) \quad ,$$

où $\varphi_n^b$ (respectivement $\varphi_n^g$) correspond à ladite porosité déterminée par ledit simulateur de bassin (respectivement par ledit simulateur géomécanique) en une maille n de ladite représentation maillée comprenant N mailles.

Selon un mode de mise en œuvre de l'invention, ledit écart peut être un écart relatif $MES^{rel}$ défini selon une formule du type :

$$MES^{rel} = \frac{2 \times max_{n \in N}\left(\left|\varphi_n^g - \varphi_n^b\right|\right)}{\varphi_n^g + \varphi_n^b} \quad ,$$

où $\varphi_n^b$ (respectivement $\varphi_n^g$) correspond à ladite porosité déterminée par ledit simulateur de bassin (respectivement par ledit simulateur géomécanique) en une maille n de ladite représentation maillée comprenant N mailles.

Selon un mode de mise en œuvre de l'invention, ledit procédé peut comprendre une étape de simulation de l'érosion d'au moins une desdites couches et/ou de simulation d'une lacune géologique.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé selon la description ci-dessus, lorsque ledit programme est exécuté sur un ordinateur.

D'autres caractéristiques et avantages du procédé selon l'invention, apparaîtront à la lecture de la description ci-après d'exemples non limitatifs de réalisations, en se référant aux figures annexées et décrites ci-après.

**Présentation succincte des figures**

- La Figure 1 montre une représentation schématique du sous-sol d'un bassin pétrolier.

- La Figure 2 montre un exemple de bassin sédimentaire (à gauche) et un exemple de représentation maillée (à droite) de ce bassin.

- La Figure 3 représente la reconstruction structurale, représenté par 3 états de déformations à trois périodes de temps différentes, d'un bassin sédimentaire.

- La Figure 4 présente une courbe représentant l'évolution de la contrainte effective en fonction de la porosité.

- La Figure 5 compare la prédiction de l'évolution de la pression de pores au sein d'un bassin sédimentaire, obtenue par le procédé selon l'invention et obtenue par un procédé selon l'art antérieur.

**Description détaillée du procédé**

L'invention concerne un procédé d'exploitation d'un bassin sédimentaire comprenant des hydrocarbures, notamment l'identification d'au moins une zone dudit bassin dans laquelle des hydrocarbures ont pu s'accumuler, en vue de l'extraction de ces hydrocarbures.

L'un des objets de l'invention concerne une reconstitution réaliste de la formation d'un bassin sédimentaire résultant du dépôt d'au moins deux couches sédimentaires, ladite reconstitution d'au moins la deuxième couche étant réalisée via un simulateur de bassin et un simulateur géomécanique coopérant entre eux. Par la suite, on considère que le dépôt d'une couche sédimentaire correspond à une période de temps (ou pas de temps) d'une simulation. A noter qu'une période de temps d'une simulation peut toutefois également correspondre à l'érosion d'une couche sédimentaire, ou encore à une lacune géologique. Selon l'invention, à partir de la reconstitution de la formation d'une première couche (par exemple la couche s'étant déposée en premier dans le bassin), on réalise une reconstitution pour une couche sus-jacente à ladite première couche, en appliquant au moins une simulation de bassin et une simulation géomécanique pour ladite couche sus-jacente de façon conjointe à au moins une couche sous-jacente (c'est-à-dire une couche déjà déposée, comme par exemple la première couche) de ce bassin.

La présente invention requiert de disposer :

- de mesures de propriétés relatives au bassin : il s'agit de mesures réalisées in situ (par exemple par carottage, via des diagraphies réalisées dans des puits, par des campagnes d'acquisition sismique, etc), en différents points du bassin étudié, nécessaires à une simulation de bassin et à une simulation géomécanique, telles que la porosité, la perméabilité, ou encore la lithologie au temps actuel. Selon un mode de mise en œuvre de l'invention visant à prendre en compte les contraintes tridimensionnelles induites par des mouvements tectoniques, il convient de disposer d'estimations de la valeur des contraintes in situ et de leur orientation dans l'espace. Ces estimations peuvent être obtenues par exemple à partir de « leak-off tests » (tests d'intégrité de puits), de mini-frac (par exemple Zoback, 2010) et d'analyse de l'ovalisation des puits. Une autre source d'information peut être l'analyse géologique de la géométrie actuelle du bassin, qui permet d'estimer les raccourcissements et extension tectonique éventuels, pour aboutir idéalement à un scénario cinématique pertinent.

- d'un simulateur de bassin, c'est-à-dire d'un logiciel permettant d'effectuer une simulation de bassin de façon numérique, à l'aide d'un ordinateur. Plus précisément, un simulateur de bassin permet de simuler numériquement l'évolution (ce qui inclut leur genèse et leur migration) des fluides (hydrocarbures, mais également l'eau de formation) au sein du bassin étudié et de leurs propriétés (évolution des pressions de fluide, des saturations et des températures), ainsi que l'évolution de propriétés pétrophysiques des roches constituant les couches sédimentaires du bassin étudié (notamment la porosité et la perméabilité). Selon l'invention, une simulation de bassin est réalisée à l'aide du simulateur de bassin pour une succession de périodes temporelles (appelées aussi pas de temps), chaque période correspondant à un événement géologique, tel que le dépôt ou l'érosion d'une couche sédimentaire, ou encore une lacune géologique. Selon l'invention, le simulateur de bassin requiert de disposer de représentations maillées du bassin pour chaque pas de temps de la simulation (la construction de telles représentations maillées sera décrite au cours des étapes 1 et 2 décrites ci-après). Ainsi, la simulation de bassin consiste en la résolution d'un système d'équations différentielles décrivant l'évolution au cours du temps des grandeurs physiques étudiées. Pour ce faire, on peut par exemple utiliser une discrétisation par la méthode des volumes finis, comme décrit par exemple dans (Scheichl et al., 2003). Conformément au principe des méthodes de volumes finis centrés sur les mailles, les inconnues sont discrétisées par une valeur constante par maille et les équations de conservation (masse ou chaleur) sont intégrées en espace sur chaque maille et en temps entre deux pas de temps successifs. Les équations discrètes expriment alors que la quantité conservée dans une maille à un pas de temps donné est égale à la quantité contenue dans la maille au pas de temps précédent, augmentée des flux de quantités entrés dans la maille et réduite des flux de quantités sorties de la maille par ses faces, plus les apports extérieurs. A chaque pas de temps et dans chaque maille de la représentation maillée du bassin au pas de temps considéré, le simulateur de bassin requis pour la mise en œuvre de l'invention permet au moins de calculer les quantités physiques suivantes : la pression de pores et la porosité. Préférentiellement, on détermine également par simulation de bassin les températures et les saturations. Un exemple d'un tel simulateur de bassin est le logiciel TemisFlow™ (IFP Énergies nouvelles, France).

- d'un simulateur géomécanique, c'est-à-dire d'un logiciel permettant d'effectuer une simulation géomécanique de façon numérique, à l'aide d'un ordinateur. Plus précisément, un simulateur géomécanique permet de simuler l'évolution des contraintes et déformations au sein d'un bassin sédimentaire au cours de sa formation. La mise en œuvre de la simulation géomécanique nécessite de disposer d'une représentation maillée du bassin étudié pour chaque période (ou pas de temps) de l'histoire du bassin pour laquelle on souhaite faire une estimation des effets géomécaniques. Selon un mode de réalisation de la présente invention, la simulation géomécanique repose sur une discrétisation et une résolution de l'équation de la conservation de la quantité de mouvement par la méthode des éléments finis (cf par exemple Zienkiewicz et al., 2013). Dans ce cas, et si la représentation maillée pour la simulation de bassin est adaptée à une résolution par la méthode des volumes finis, on peut déterminer une représentation maillée adaptée à la simulation géomécanique à partir d'une représentation maillée adaptée à la simulation de bassin par un remaillage. L'étape de remaillage peut consister en le découpage des hexaèdres dégénérés, éventuellement présents dans les maillages adaptés à une résolution par la méthode des volumes finis, en des tétraèdres adaptés à une résolution par la méthode des éléments finis. Dans le cas de représentations maillées différentes entre simulation de bassin et simulation géomécanique, on peut aussi assurer la correspondance entre les deux représentations maillées via un algorithme dit de « mapping » (« cartographie » en français). Le simulateur géomécanique selon l'invention requiert au moins une valeur de pression de pores pour chaque pas de temps et en chaque maille de la représentation maillée relative au pas de temps considéré, et permet de calculer au moins le tenseur des contraintes et le tenseur des déformations en chacune des mailles de la représentation maillée, à partir d'un état initial défini en termes de contraintes, pressions et porosités. En outre, chaque maille de la représentation maillée associée à un pas de temps donné est associée au moins à une loi de comportement géomécanique. La loi de comportement géomécanique peut être exprimée par un module d'Young, un coefficient de Poisson, une limite d'élasticité et/ou encore une loi d'écrouissage, ces paramètres peuvent être estimés à partir du faciès (argile, sable, etc) présent dans la maille considérée. Selon un mode de mise en œuvre de l'invention, le simulateur géomécanique peut en outre prendre en compte des conditions aux limites, permettant notamment de prendre en compte des mouvements tectoniques régionaux. Un exemple d'un tel simulateur géomécanique est le logiciel ABAQUS™ (Dassault Systèmes, France).

La présente invention comporte alors au moins les étapes suivantes

1. Construction de représentations maillées du bassin

2. Reconstitution de la formation du bassin

    2.1. Application d'une simulation de bassin

    2.2. Application d'une simulation géomécanique

    2.3. Contrôle de cohérence

3. Exploitation du bassin sédimentaire

Les principales étapes de la présente invention sont détaillées ci-après.

1. Construction de représentations maillées du bassin

La mise en œuvre de l'invention repose sur une simulation de bassin coopérant avec une simulation géomécanique. Par conséquent le procédé selon l'invention requiert de disposer d'une représentation maillée pour chaque pas de temps de simulation considéré pour la mise en œuvre de l'invention, un pas de temps correspondant au dépôt d'une couche sédimentaire, à une lacune géologique, ou encore à l'érosion d'une couche sédimentaire.

Selon un mode de mise en œuvre de l'invention, cette étape est réalisée tout d'abord en établissant une représentation maillée du bassin étudié au temps actuel (étape 1.1), puis en reconstruisant les architectures passées du bassin (étape 1.2), en partant du temps actuel jusqu'à un temps géologique t, antérieur à l'actuel. Ce mode particulier de mise en œuvre de l'invention est décrit plus en détail ci-après.

1.1 Construction d'une représentation maillée au temps actuel

Une représentation maillée est une maquette du bassin sédimentaire généralement représentée sur ordinateur, sous la forme d'un maillage ou grille, chaque maille étant caractérisée par une ou plusieurs propriétés pétrophysiques relatives au bassin, telles que porosité, faciès, perméabilité etc. La construction de ce modèle se base sur des données acquises au cours de campagnes sismiques, de mesures dans des puits, de carottages, etc.

Plus précisément, la construction d'une représentation maillée d'un bassin consiste à discrétiser en trois dimensions l'architecture du bassin, à attribuer des propriétés à chacune des mailles de cette représentation maillée, et à ajouter des conditions aux limites de cette représentation pour rendre compte de l'interaction de la zone modélisée avec son environnement. Pour ce faire, on exploite notamment les mesures de propriétés réalisées en différents points du bassin décrites ci-dessus, que l'on extrapole et/ou interpole, en les différentes mailles de la représentation maillée, suivant des hypothèses plus ou moins restrictives.

Le plus souvent la discrétisation spatiale d'un bassin sédimentaire est organisée en couches de mailles, représentant chacune les différentes couches géologiques du bassin étudié. La Figure 2 illustre à gauche un exemple de bassin sédimentaire, et à droite un exemple de représentation maillée de ce bassin.

La représentation maillée pouvant être utilisée pour la mise en œuvre de l'invention comprend notamment en chaque maille une information sur la lithologie, une valeur de porosité, une valeur de perméabilité, ainsi que des propriétés relatives aux fluides (notamment la saturation). A noter que le spécialiste est à même de déduire, à partir de ces quantités, des informations relatives à la compaction dans chacune des mailles de la représentation maillée.

1.2. Reconstruction structurale

Au cours de cette sous-étape, il s'agit de reconstruire les architectures passées du bassin, en partant du temps actuel jusqu'à un temps géologique t, antérieur à l'actuel. Pour ce faire, on déforme la représentation maillée construite à l'étape précédente afin de représenter l'évolution anti-chronologique de l'architecture du sous-sol au cours des temps géologiques, et ce pour chaque pas de temps de la simulation. On obtient ainsi une représentation maillée pour chaque pas de temps de la simulation, depuis le temps actuel jusqu'au temps géologique t.

Selon un mode de réalisation de la présente invention, la reconstruction structurale peut être particulièrement simple si elle se base sur l'hypothèse que sa déformation résulte uniquement d'une combinaison de mouvements verticaux par compaction du sédiment ou par surrection ou affaissement de son socle. Cette technique, connue sous le terme de « backstripping » (ou «décompaction progressive du bassin » en français) est décrite par exemple dans (Steckler et Watts, 1978).

Selon un autre mode de réalisation de la présente invention, dans le cas de bassins dont l'histoire tectonique est complexe, notamment dans le cas de bassins présentant des failles, il convient d'utiliser des techniques aux hypothèses moins restrictives, telles que la restauration structurale. Une telle restauration structurale est décrite par exemple dans le document FR 2 930 350 A (US 2009/0265152 A). La restauration structurale consiste à calculer les déformations successives que le bassin a subies, en intégrant les déformations dues à la compaction et celles qui résultent des forces tectoniques. Dans l'exemple de la Figure 3, trois états sont utilisés pour représenter la déformation du sous-sol au cours des temps géologiques. La représentation maillée de gauche représente l'état actuel, où l'on peut observer une interface de glissement (ici une faille). La représentation maillée de droite représente le même bassin sédimentaire à un temps géologique t, antérieur à l'actuel. A ce temps t, les couches sédimentaires n'étaient pas encore fracturées. La représentation maillée centrale est un état intermédiaire, c'est-à-dire qu'elle représente le bassin sédimentaire à un temps *t',* compris entre le temps *t* et l'actuel. On constate que le glissement a commencé à modifier l'architecture du bassin.

2. Reconstitution de la formation du bassin

Au cours de cette étape, il s'agit de reconstituer la formation du bassin étudié, à partir des représentations maillées établies aux étapes précédentes, au moyen d'un simulateur de bassin et d'un simulateur géomécanique coopérant entre eux.

Pour ce faire, il est nécessaire de disposer préalablement d'une reconstitution de la formation de la première des couches du bassin sédimentaire étudié, c'est-à-dire celle s'étant déposée la première dans le bassin, ou encore la couche la plus ancienne. Cette reconstitution de la première des couches peut avoir été obtenue par tout moyen. Selon un mode de mise en œuvre de la présente invention, cette reconstitution est obtenue par une simulation de bassin.

Puis, pour au moins une couche s'étant déposée ultérieurement à la première couche (c'est-à-dire une couche située au-dessus de la première des couches), on applique au moins une simulation de bassin suivie d'une simulation géomécanique, lesdites simulations prenant en compte conjointement la couche considérée et au moins une couche sous-jacente à la couche considérée, la coopération étant assurée par le transfert d'une partie des paramètres en sortie de la simulation de bassin à la simulation géomécanique.

Préférentiellement, pour une couche donnée, la simulation de bassin est appliquée en coopération à la simulation géomécanique pour la couche considérée, conjointement à toutes les couches précédemment déposées (c'està-dire à toutes les couches sous-jacentes à la couche considérée).

Ainsi selon l'invention, on met en œuvre les sous-étapes suivantes pour chaque couche considérée, les sous-étapes 2.1 à 2.3 étant répétées pour au moins chaque couche considérée :

2.1. <u>Application d'une simulation de bassin</u>

Au cours de cette sous-étape, il s'agit d'appliquer une simulation de bassin, au moyen d'un simulateur de bassin, à la couche considérée, conjointement à au moins une couche sous-jacente, c'est-à-dire une couche déjà déposée. La simulation de bassin conjointe de plusieurs couches sédimentaires permet de prendre en compte les contraintes imposées par le dépôt des couches sus-jacentes sur les couches sous-jacentes.

Ainsi, la simulation de bassin appliquée selon l'invention permet de calculer des paramètres pour la couche considérée, mais permet aussi de mettre à jour des paramètres calculés pour la couche précédemment déposée et considérée conjointement avec la couche en cours.

Selon l'invention, la simulation de bassin pour la couche considérée est mise en œuvre en utilisant la représentation maillée déterminée au cours de l'étape 2 précédente pour la période de temps correspondant au dépôt de la couche courante. Selon un mode de mise en œuvre de l'invention, ladite représentation maillée requise contient en chaque maille des informations usuelles en simulation de bassin, telles que des propriétés pétrophysiques relatives à la lithologie, des informations caractérisant le type de compaction, des propriétés relatives aux fluides présents dans la formation à la période de temps considérée, ainsi que les limites et géométries des couches déjà déposées.

Selon un mode de mise en œuvre de l'invention, le simulateur de bassin utilisé pour la mise en œuvre de la présente invention permet de discrétiser et résoudre les équations décrite dans le document (Schneider et al., 2000). Le logiciel TemisFlow™ (IFP Énergies nouvelles, France) est un exemple d'un tel simulateur de bassin.

A l'issue de l'application de la simulation de bassin pour la période de temps considérée, on obtient un premier jeu de paramètres, tels que des pressions de pores, des saturations, des températures, des porosités dans chacune des mailles de la représentation maillée représentative de la période considérée. Selon l'invention, ce premier jeu de paramètres comprend au moins les porosités en chaque maille de la représentation maillée pour la période considérée. Selon un mode de mise en œuvre de l'invention, ce premier jeu de paramètres comprend au moins les pressions de pores et les porosités en chaque maille de la représentation maillée pour la période considérée.

2.2 <u>Application d'une simulation géomécanique</u>

Au cours de cette sous-étape, il s'agit de réaliser une simulation géomécanique, pour la même période de temps que celle considérée pour la sous-étape précédente. Selon l'invention, la simulation géomécanique est appliquée conjointement à la couche s'étant déposée lors de la période en cours et à au moins à une autre couche s'étant déposée à une période de temps antérieure. La simulation géomécanique conjointe de plusieurs couches sédimentaires permet de prendre en compte les contraintes mécaniques imposées par le dépôt des couches sus-jacentes sur les couches sous-jacentes.

Préférentiellement, on appliquera la simulation géomécanique à l'ensemble des couches déposées jusqu'à la période de temps considérée. Autrement dit, la simulation géomécanique à une période de temps donnée est mise en œuvre en incluant toute la colonne de couches sédimentaires déjà déposées jusqu'à cette période. De cette façon, le procédé selon l'invention permet de non seulement simuler les effets géomécaniques tridimensionnels qui se sont produits dans la couche déposée pendant la période de temps considérée, mais aussi les effets produits sur toutes les couches déjà déposées jusqu'à la période de temps considérée.

Selon l'invention, la simulation géomécanique est réalisée à partir d'une représentation maillée représentative du bassin pour la période de temps considérée. Selon un mode de mise en œuvre de l'invention, il peut s'agir de la représentation maillée utilisée pour la simulation de bassin lors de la mise en œuvre de la sous-étape précédente, éventuellement adaptée à la méthode de résolution des équations requises par la simulation géomécanique comme décrit précédemment.

Selon l'invention, une partie du premier jeu de paramètres, calculé à la sous-étape précédente pour la même période de temps, est transmis au simulateur géomécanique. Selon un mode de mise en œuvre de l'invention, une partie du premier jeu de paramètres calculé à la sous-étape précédente correspond à la pression au début et à la fin de la période de temps considérée (on parle d'historique de pressions) par la simulation de bassin. Cet historique de pressions peut alors être utilisé comme une contrainte pour la simulation géomécanique relative à la période de temps considérée. Selon un autre mode de mise en œuvre, on transmet en outre à la simulation géomécanique les températures et/ou les saturations déterminées par simulation de bassin à la sous-étape précédente. Selon un mode de mise en œuvre de l'invention, dans le cas de représentations maillées différentes entre simulation de bassin et simulation géomécanique, on peut assurer la correspondance entre les deux représentations maillées via un algorithme dit de « mapping » (« cartographie » en français).

Préférentiellement, la simulation géomécanique prend aussi en compte des contraintes mécaniques liées aux mouvements tectoniques régionaux subis par le bassin sédimentaire étudié. Selon un mode de mise en œuvre de l'invention, ces contraintes mécaniques sont prises en compte comme conditions aux limites lors des simulations géomécaniques, imposant par exemple à la simulation géomécanique de vérifier, sur les bords du domaine de simulation, des déplacements horizontaux (traduisant une compression ou une extension). La prise en compte de telles conditions aux limites peut être réalisée selon la méthode des éléments finis via l'utilisation de conditions aux limites en déplacement ou contraintes. Ainsi, selon ce mode de réalisation, la représentation maillée pour la période de temps considérée se déforme au cours de l'étape de simulation géomécanique, en respectant les conditions aux limites établies.

A l'issue de cette sous-étape, on obtient un deuxième jeu de paramètres relatif à la période de temps considérée. Selon un mode de mise en œuvre de l'invention, ce deuxième jeu de paramètres comprend au moins les porosités en chaque maille de la représentation maillée pour la période considérée. A noter que la représentation maillée à la fin d'un pas de temps d'une simulation géomécanique n'est pas nécessairement identique à la représentation maillée issue de l'étape de reconstruction structurale et déterminée au cours de l'étape 2 pour le pas de temps suivant.

### 2.3 Contrôle de cohérence

Au cours de cette étape, il s'agit d'effectuer un contrôle de cohérence entre au moins une partie des paramètres du premier jeu de paramètres, déterminé à l'étape 2.1 par simulation de bassin, et au moins une partie des paramètres du deuxième jeu de paramètres, déterminé à l'étape 2.2 par simulation géomécanique. Pour ce faire, selon l'invention, on mesure un écart entre au moins une partie des paramètres du premier jeu (issu de la simulation de bassin) et au moins une partie des paramètres du deuxième jeu (issu de la simulation géomécanique) et on vérifie si cet écart s'inscrit ou non au-delà d'un certain seuil prédéfini par le spécialiste.

Selon un mode de mise en œuvre de l'invention, ledit écart est évalué en comparant les porosités estimées par simulation de bassin et les porosités estimées par simulation géomécanique. L'écart peut être estimé maille à maille si les modèles bassin et géomécaniques ont des maillages identiques, sinon, on a recours à une technique de transfert de champs, bien connue du spécialiste. On trouvera par exemple une référence concernant une telle technique dans le document (Nayroles et al., 1991)

Selon un mode de mise en œuvre de l'invention, on calcule, pour le pas de temps t considéré, un écart $MES_t$ selon une formule du type :

$$MES_t^{abs} = max_{n \in N}\left(\left|\varphi_{n,t}^g - \varphi_{n,t}^b\right|\right) \qquad (1)$$

où $\varphi_{n,t}^b$ (respectivement $\varphi_{n,t}^g$ ) est la porosité déterminée par simulation de bassin (respectivement pas simulation géomécanique) en une maille n de la représentation maillée relative au pas de temps t., la représentation maillée comprenant N mailles. A noter que si le simulateur géomécanique ne détermine pas directement la porosité, celle-ci peut être obtenue par la formule : $\varphi_{me} = (V_T - V_S)/V_T$ avec $V_T$ correspondant à au volume total de la maille et $V_s$ au volume solide dans la maille. Selon ce mode de mise en œuvre, on considère que les prédictions de porosité sont cohérentes entre simulation géomécanique et simulation de bassin pour le pas de temps t considéré lorsque l'écart entre ces deux prédictions est inférieure à une valeur de seuil prédéfinie par le spécialiste. Avantageusement, la valeur de seuil prédéfinie peut être comprise en 0,0001 et 0,02. Préférentiellement, on considère que les prédictions de porosité sont cohérentes entre simulation géomécanique et simulation de bassin pour le pas de temps t considéré lorsque $MES_t$ $\leq 0.001$ .

Selon un autre mode de mise en œuvre de l'invention, on calcule un écart relatif $MES_t^{rel}$ basé sur une formule

$$MES_t^{rel} = \frac{2 \times max_n\left(\left|\varphi_{n,t}^g - \varphi_{n,t}^b\right|\right)}{\varphi_{n,t}^g + \varphi_{n,t}^b}$$

. Selon ce mode de mise en œuvre, on considère que les prédictions de porosité sont cohérentes entre simulation géomécanique et simulation de bassin pour le pas de temps t considéré lorsque l'écart entre ces deux prédictions est inférieure à une valeur prédéfinie par le spécialiste. Avantageusement, la valeur de seuil prédéfinie peut être comprise en 0,0001 et 0,02. Préférentiellement, on considère que les prédictions de porosité sont cohérentes entre simulation géomécanique et simulation de bassin pour le pas de temps t considéré lorsque $MES_t^{rel} \leq 0.001$.

Selon l'invention, si le critère de cohérence n'est pas vérifié, on estime une correction à appliquer en entrée d'une nouvelle simulation de bassin, qui est mise en œuvre pour le même pas de temps. Cette correction a pour but de forcer la convergence entre les résultats de la simulation géomécanique et les résultats de la simulation de bassin.

Selon un mode de réalisation de l'invention, cette correction peut être une correction des perméabilités et/ou une correction des contraintes à appliquer en chacune des mailles de la représentation maillée relative au pas de temps considéré, et ce avant l'application d'une nouvelle simulation de bassin.

Selon un mode de mise en œuvre de l'invention, on estime une correction de contraintes à appliquer en chacune des mailles de la représentation maillée au pas de temps t en exploitant la différence entre les porosités calculées par le simulateur de bassin et celles calculées par la simulation géomécanique, ainsi qu'une loi de compaction des dépôts sédimentaires. Selon un mode particulier de mise en œuvre de l'invention, on considère une loi de compaction f reliant porosités et contraintes effectives, et on calcule une correction de contraintes $\Delta\sigma_{n,t}^{eff}$ à appliquer en entrée de la simulation de bassin pour un pas de temps t et une maille n selon une formule du type :

$$\Delta\sigma_{n,t}^{eff} = f^{-1}\left(\varphi_{n,t}^g\right) - f^{-1}\left(\varphi_{n,t}^b\right), \tag{2}$$

où f représente une loi de compaction des dépôts sédimentaires, qui peut être du type :

$$f\left(\sigma_{n,t}^{eff}\right) = \varphi_0 + \varphi_a \exp\left(-\sigma_{n,t}^{eff}/\sigma_a\right) + \varphi_b \exp\left(-\sigma_{n,t}^{eff}/\sigma_b\right), \tag{3}$$

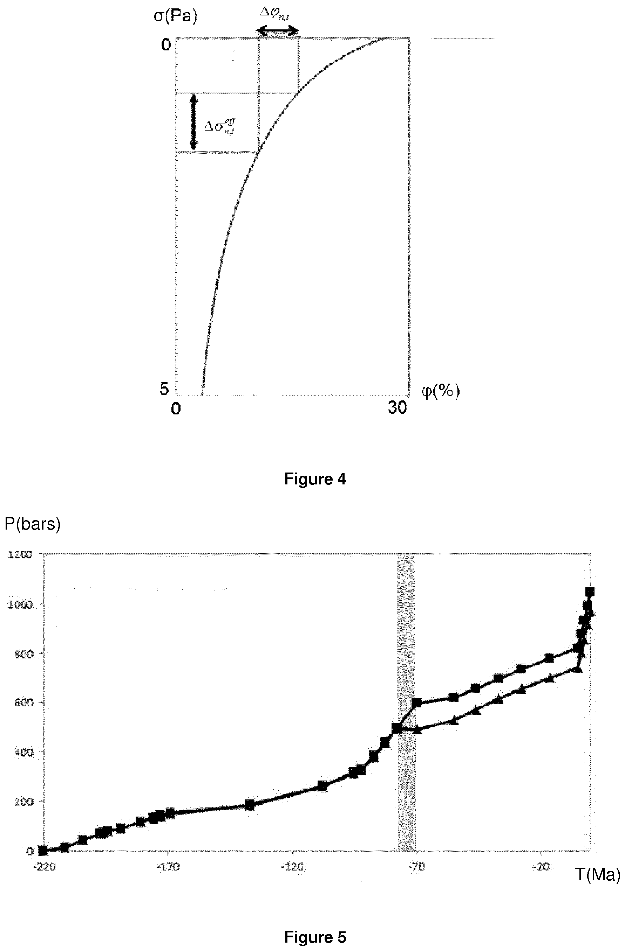

où $\varphi_0$, $\varphi_a$, $\varphi_b$, $\sigma_a$ et $\sigma_b$ étant des propriétés caractérisant la compaction du sédiment considéré, propriétés que le spécialiste peut déterminer à partir des mesures de propriétés relatives audit bassin (cf. étape 1). La Figure 4 présente notamment comment déduire, à partir d'une loi de compaction f (courbe continue) et d'un différentiel de porosité $\Delta\varphi_{n,t}$ un différentiel de contraintes effectives $\Delta\sigma_{n,t}^{eff}$ pour une maille n à un pas de temps t. La prise en compte de corrections de contraintes dans une nouvelle simulation de bassin pour la couche en cours a pour effet d'influencer l'évolution de la porosité au cours de la période simulée, et ainsi de rapidement conduire à la convergence des paramètres issus de la simulation de bassin et ceux issus de la simulation géomécanique.

Selon un autre mode de mise en œuvre de l'invention, on estime une correction de perméabilité, à appliquer en chacune des mailles de la représentation maillée au pas de temps t, à l'aide des estimations des contraintes issues de la dernière simulation géomécanique et de considérations sur l'état géomécanique des matériaux, déduites de leur porosité ou encore de leur état de détérioration ou de fracturation. Par exemple, cette correction peut conduire à une augmentation significative de la perméabilité d'une maille ayant atteint un état de contrainte critique au regard du critère de rupture associé à sa loi de comportement géomécanique. La prise en compte de corrections de perméabilité dans une nouvelle simulation de bassin pour le pas de temps considéré a pour effet d'influencer, entre autres, l'évolution des pressions et surpressions, et ainsi de conduire à des résultats potentiellement plus pertinents. Selon un mode de mise en œuvre de l'invention, dans le cas de représentations maillées différentes entre simulation de bassin et simulation géomécanique, on peut assurer la correspondance entre les deux représentations maillées via un algorithme dit de « mapping » (« cartographie » en français).

Selon un autre mode de mise en œuvre de l'invention, on estime à la fois une correction de perméabilités et une correction de contraintes en chacune des mailles de la représentation maillée au pas de temps considéré. La prise en compte de corrections de contraintes et de corrections de perméabilités dans une nouvelle simulation de bassin pour le pas de temps considéré a pour effet d'influencer l'évolution entre autres de la porosité, des pressions et surpressions et ainsi de rapidement conduire à la convergence des paramètres issus de la simulation de bassin et ceux issus de la simulation géomécanique ainsi qu'à des résultats potentiellement plus pertinents.

Ainsi, selon l'invention, si la cohérence des paramètres des deux simulations n'est pas vérifié, c'est-à-dire si l'écart entre au moins une partie des paramètres issus de la simulation de bassin et au moins une partie des paramètres issus de la simulation géomécanique pour le pas de temps courant est supérieur à un seuil prédéfini par le spécialiste, on détermine une correction à apporter à la simulation de bassin et on réitère les sous-étapes 2.1 à 2.3 jusqu'à ce que ledit écart soit inférieur audit seuil.

Sinon, selon l'invention, une fois que la cohérence des paramètres des deux simulations est vérifiée, c'est-à-dire si l'écart entre au moins une partie des paramètres issus de la simulation de bassin et au moins une partie des paramètres issus de la simulation géomécanique pour le pas de temps courant est inférieur au seuil prédéfini par le spécialiste, on applique les sous-étapes 2.1 à 2.3 décrites précédemment pour le pas de temps suivant.

Cette étape permet ainsi de garantir une reconstruction réaliste du bassin .

3. Exploitation du bassin sédimentaire

A l'issue de l'application de l'étape précédente pour chacune des périodes de temps à considérer pour la reconstitution de la formation du bassin étudié, on dispose d'informations générales telles que :

i. la mise en place des couches sédimentaires,

ii. leur réchauffement au cours de leur enfouissement,

iv. les modifications de pressions de fluides résultant de cet enfouissement,

v. la formation des hydrocarbures formés par thermogénèse,

vi. le déplacement de ces hydrocarbures dans le bassin sous l'effet de la flottabilité, de la capillarité, des différences de gradients de pression les écoulements souterrains,

vii. la quantité d'hydrocarbures issus de la thermogénèse dans les mailles de chacune des représentations maillées dudit bassin,

viii. l'évolution des contraintes et déformations tridimensionnelles au cours de la formation dudit bassin.

A partir de telles informations et notamment à partir de ces informations pour la période de temps actuel, le spécialiste peut déterminer au moins une zone du bassin, correspondant à des mailles de ladite représentation maillée au temps actuel dudit bassin, comportant des hydrocarbures, ainsi que la teneur, la nature et la pression des hydrocarbures qui y sont piégés. Le spécialiste est alors en mesure de sélectionner les zones du bassin étudié présentant le meilleur potentiel pétrolier.

L'exploitation pétrolière du bassin peut alors prendre plusieurs formes, notamment :

- la réalisation de forages d'exploration dans les différentes zones sélectionnées comme présentant le meilleur potentiel, afin de confirmer ou infirmer le potentiel estimé préalablement, et d'acquérir de nouvelles données pour alimenter de nouvelles études plus précises,
- la réalisation de forages d'exploitation (puits producteurs ou injecteurs) pour la récupération des hydrocarbures présents au sein du bassin sédimentaire dans les zones sélectionnées comme présentant le meilleur potentiel.

**Produit programme d'ordinateur**

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé tel que décrit précédemment, lorsque ledit programme est exécuté sur un ordinateur.

**Variantes**

Selon un mode de mise en œuvre de la présente invention, la reconstitution relative à la première couche du bassin sédimentaire considéré est réalisée selon une simulation de bassin coopérant avec une simulation géomécanique. Plus précisément, on réalise une simulation de bassin relative à la première couche, et on détermine un premier jeu de paramètres. Puis, à partir d'au moins une partie du premier jeu de paramètres et d'un simulateur géomécanique, on réalise une simulation géomécanique relative à la première couche, et on détermine un deuxième jeu de paramètres. Puis, on mesure un écart entre au moins une partie des paramètres du premier jeu et au moins une partie des paramètres du deuxième jeu (par exemple comme décrit précédemment dans l'étape 2.3). Si cet écart est supérieur à un seuil prédéfini par le spécialiste, on calcule une correction (par exemple de contraintes ou de perméabilité, comme décrit précédemment dans l'étape 2.3) à appliquer à une nouvelle simulation de bassin pour la même première couche, suivie d'une simulation géomécanique, et ce jusqu'à ce que l'écart mesuré respecte le seuil prédéfini par le spécialiste.

Selon un mode de mise en œuvre de l'invention, le simulateur de bassin et le simulateur géomécanique utilisés pour la mise en œuvre des étapes 2.1 et 2.2 décrites précédemment permettent de simuler, le cas échéant, l'érosion d'au moins une des couches du bassin sédimentaire considéré et/ou de simuler une lacune géologique à une période de temps considérée. De préférence, lesdites simulations d'une érosion et/ou d'une lacune sont réalisées conjointement à au moins une couche précédemment déposée et, le cas échéant, non affectée par ladite érosion. Avantageusement, lesdites simulations d'une érosion et/ou d'une lacune sont réalisées conjointement à l'ensemble des couches précédemment déposées et, le cas échéant, non affectées par ladite érosion. Selon ce dernier mode de mise en œuvre de l'invention, le procédé selon l'invention peut permettre de simuler l'évolution de la porosité, de la perméabilité, du champ de contraintes et du champ de pressions induite dans le bassin sédimentaire étudié par soit une érosion totale ou partielle d'une couche sédimentaire du bassin étudié, et/ou induite par une lacune géologique.

## Exemple d'application

Les caractéristiques et avantages du procédé selon l'invention apparaîtront plus clairement à la lecture de l'exemple d'application ci-après.

Le procédé selon l'invention a été mis en œuvre dans le cas de la formation d'un bassin sédimentaire résultant du dépôt, à vitesse variable, d'une série couches argileuses pendant 220 millions d'années, la colonne argileuse atteignant près de 6000 mètres de hauteur au temps actuel. En plus des effets mécaniques liés aux dépôts sédimentaires successifs, ce bassin est soumis, entre -78 et -72 millions d'années, à une phase tectonique extensive (extension de 10%), engendrant des variations de contraintes mécaniques tridimensionnelles.

La Figure 5 présente deux courbes :

- une première courbe, représentée avec des carrés , et qui correspond à l'évolution au cours des temps géologiques T de la pression de pores P prédite au niveau de la première couche argileuse (c'est-à-dire la couche la plus profonde) par le procédé selon l'invention, celui-ci étant mis en œuvre en prenant en compte les variations de contraintes tridimensionnelles induites par les dépôts ultérieurs à la couche considérée, ainsi que les variations de contraintes issues de mouvements tectoniques. De plus, le contrôle de cohérence entre le jeu de paramètres issu de la simulation de bassin et le jeu de paramètres issu de la simulation géomécanique, décrit précédemment à l'étape 2.3, a été réalisé avec une valeur de seuil de 0.001 ;
- une deuxième courbe, représentée avec des triangles, et qui correspond aussi à l'évolution au cours des temps géologiques T de la pression de pores P prédite au niveau de la première couche argileuse mais par un procédé selon l'art antérieur, c'est-à-dire un procédé ne prenant pas en compte ni les variations de contraintes tridimensionnelles induites par les dépôts ultérieurs à la couche considérée, ni les variations de contraintes issues de mouvements tectoniques s'étant produits après le dépôt de la couche considérée.

On observe sur cette Figure que la prise en compte des contraintes mécaniques tridimensionnelles pour la couche la plus profonde, et ce tout au long de la formation du bassin, permet de prédire une chute de pression de 100 bars dans ladite couche, cette chute étant induite par l'épisode de tectonique extensive (délimité sur l'axes des temps géologiques par une zone grisée) survenu postérieurement à son dépôt. Ce phénomène tectonique étant survenu après le dépôt de la couche considérée, il est négligé par le procédé selon l'art antérieur, ce qui induit une erreur de prédiction de la pression de pores de 100 bars dans la couche considérée au temps actuel. Une telle erreur peut conduire à fortement fausser l'appréciation du potentiel pétrolier de ladite couche. Par exemple, le spécialiste pourra juger que les pressions dans la couche considérée sont insuffisantes pour permettre une extraction pétrolière rentable.

Ainsi la prise en compte des variations tridimensionnelles des contraintes mécaniques subies par un bassin sédimentaire tout au long de sa formation apparaît fondamentale pour une appréciation juste du potentiel pétrolier d'un bassin sédimentaire.

## Revendications

1. Procédé d'exploitation d'un bassin sédimentaire comportant des hydrocarbures, comprenant une reconstitution de la formation dudit bassin, ladite formation comprenant au moins le dépôt de deux couches sédimentaires, ladite reconstitution étant réalisée au moyen d'un simulateur de bassin et d'un simulateur géomécanique coopérant entre eux, au moyen de mesures de propriétés relatives audit bassin et de représentations maillées représentatives dudit bassin au moment du dépôt de chacune desdites couches sédimentaires, et dans lequel, à partir desdites mesures et d'une reconstitution de ladite formation de la première desdites couches, ladite reconstitution pour au moins une desdites couches sus-jacentes à ladite première couche est mise en œuvre selon au moins l'étape suivante :

A. au moyen dudit simulateur de bassin, on réalise une simulation de bassin conjointe de ladite couche et d'au moins une couche sous-jacente à ladite couche, et on détermine un premier jeu de paramètres ;

ledit procédé étant **caractérisé en ce que** ladite reconstitution pour au moins ladite desdites couches sus-jacentes à ladite première couche comprend en outre les étapes suivantes :

B. à partir d'au moins une partie dudit premier jeu desdits paramètres et dudit simulateur géomécanique, on réalise une simulation géomécanique conjointe de ladite couche et d'au moins une couche sous-jacente à ladite couche, et on détermine un deuxième jeu de paramètres ;

C. on mesure un écart entre au moins une partie desdits paramètres dudit premier jeu et au moins une partie desdits paramètres dudit deuxième jeu, et on réitère les étapes A) à C) en appliquant une correction à ladite simulation de bassin si ledit écart est supérieur à un seuil prédéfini ;

et **en ce que**, au moyen de ladite reconstitution réalisée pour lesdites couches, on sélectionne au moins une zone dudit bassin comportant lesdits hydrocarbures, et on exploite ledit bassin en fonction de ladite zone sélectionnée.

2. Procédé selon la revendication 1, dans lequel ladite reconstitution relative à ladite première couche est réalisée selon au moins les étapes suivantes :

i. au moyen dudit simulateur de bassin, on réalise une simulation de bassin relative à ladite première couche, et on détermine un premier jeu de paramètres ;

ii. à partir d'au moins une partie dudit premier jeu desdits paramètres et dudit simulateur géomécanique, on réalise une simulation relative à ladite première couche, et on détermine un deuxième jeu de paramètres ;

iii. on mesure un écart entre au moins une partie desdits paramètres dudit premier jeu et au moins une partie desdits paramètres dudit deuxième jeu, et on réitère les étapes i) à iii) en appliquant une correction à ladite simulation de bassin si ledit écart est supérieur à un seuil prédéfini.

3. Procédé selon l'une des revendications précédentes, dans lequel ledit premier jeu de paramètres comprend au moins la porosité et la pression en chacune des mailles de ladite représentation maillée.

4. Procédé selon la revendication 3, dans lequel ledit deuxième jeu de paramètres comprend au moins la porosité en chacune des mailles de ladite représentation maillée.

5. Procédé selon l'une des revendications 3 à 4, dans lequel ledit écart est fondé sur une mesure de la différence entre ladite porosité issue dudit premier jeu de et ladite porosité issue dudit deuxième jeu.

6. Procédé selon la revendication 5, dans lequel ledit écart est un écart absolu *MES^{abs}* défini selon une formule du type :

$$MES^{abs} \;=\; max_{n \in N}\left(\left|\varphi_n^g - \varphi_n^b\right|\right) \quad,$$

où $\varphi_n^b$ (respectivement $\varphi_n^g$) correspond à ladite porosité déterminée par ledit simulateur de bassin (respectivement par ledit simulateur géomécanique) en une maille *n* de ladite représentation maillée comprenant N mailles.

7. Procédé selon la revendication 5, dans lequel ledit écart est un écart relatif *MES^{rel}* défini selon une formule du type :

$$MES^{rel} \;=\; \frac{2 \times max_{n \in N}\left(\left|\varphi_{n,}^g - \varphi_{n,}^b\right|\right)}{\varphi_n^g + \varphi_n^b} \quad,$$

où $\varphi_n^b$ (respectivement $\varphi_n^g$) correspond à ladite porosité déterminée par ledit simulateur de bassin (respectivement par ledit simulateur géomécanique) en une maille n de ladite représentation maillée comprenant N mailles.

8. Procédé selon l'une des revendications précédentes, dans lequel ledit procédé comprend une étape de simulation de l'érosion d'au moins une desdites couches et/ou de simulation d'une lacune géologique.

9. Produit programme d'ordinateur téléchargeable depuis un réseau de communication et/ou enregistré sur un support lisible par ordinateur et/ou exécutable par un processeur, comprenant des instructions de code de programme pour la mise en œuvre du procédé selon l'une des revendications précédentes, lorsque ledit programme est exécuté sur un ordinateur.

**Patentansprüche**

1. Verfahren zur Erschließung eines Sedimentbeckens, das Kohlenwasserstoffe umfasst, beinhaltend eine Rekonstruktion der Bildung des Beckens, wobei die Bildung mindestens die Ablagerung von zwei Sedimentschichten beinhaltet, wobei die Rekonstruktion mit Hilfe eines Beckensimulators und eines geomechanischen Simulators, die zusammenarbeiten, mit Hilfe von Messungen von Eigenschaften des Beckens und Maschendarstellungen, die für das Becken zum Zeitpunkt der Ablagerung jeder der Sedimentschichten repräsentativ sind, durchgeführt wird und wobei anhand der Messungen und einer Rekonstruktion der Bildung der ersten der Schichten die Rekonstruktion für mindestens eine der Schichten, die über der ersten Schicht liegen, gemäß mindestens dem folgenden Schritt umgesetzt wird:

A. mit Hilfe des Beckensimulators, Durchführen einer gemeinsamen Beckensimulation der Schicht und mindestens einer unter der Schicht liegenden Schicht und Bestimmen eines ersten Satzes Parameter;
wobei das Verfahren **dadurch gekennzeichnet ist, dass** die Rekonstruktion für mindestens die eine der über der ersten Schicht liegenden Schichten ferner die folgenden Schritte beinhaltet:
B. anhand mindestens eines Teils des ersten Satzes der Parameter und des geomechanischen Simulators, Durchführen einer gemeinsamen geomechanischen Simulation der Schicht und mindestens einer unter der Schicht liegenden Schicht und Bestimmen eines zweiten Satzes Parameter;
C. Messen einer Abweichung zwischen mindestens einem Teil der Parameter des ersten Satzes und mindestens einem Teil der Parameter des zweiten Satzes und Wiederholen der Schritte A) bis C), indem eine Korrektur auf die Beckensimulation angewandt wird, wenn die Abweichung größer als ein vordefinierter Schwellenwert ist;

und dass mit Hilfe der Rekonstruktion, die für die Schichten durchgeführt wird, mindestens ein Bereich des Beckens ausgewählt wird, der die Kohlenwasserstoffe umfasst, und das Becken in Abhängigkeit von dem ausgewählten Bereich erschlossen wird.

2. Verfahren nach Anspruch 1, wobei die Rekonstruktion der ersten Schicht mindestens gemäß den folgenden Schritten durchgeführt wird:

i. mit Hilfe des Beckensimulators, Durchführen einer Beckensimulation der ersten Schicht und Bestimmen eines ersten Satzes Parameter;
ii. anhand mindestens eines Teils des ersten Satzes der Parameter und des geomechanischen Simulators, Durchführen einer Simulation der ersten Schicht und Bestimmen eines zweiten Satzes Parameter;
iii. Messen einer Abweichung zwischen mindestens einem Teil der Parameter des ersten Satzes und mindestens einem Teil der Parameter des zweiten Satzes und Wiederholen der Schritte i) bis iii), indem eine Korrektur auf die Beckensimulation angewandt wird, wenn die Abweichung größer als ein vordefinierter Schwellenwert ist.

3. Verfahren nach einem der vorhergehenden Ansprüche, wobei der erste Satz Parameter mindestens die Porosität und den Druck in jeder der Maschen der Maschendarstellung beinhaltet.

4. Verfahren nach Anspruch 3, wobei der zweite Satz Parameter mindestens die Porosität in jeder der Maschen der Maschendarstellung beinhaltet.

5. Verfahren nach einem der Ansprüche 3 bis 4, wobei die Abweichung auf einer Messung des Unterschieds zwischen der Porosität aus dem ersten Satz und der Porosität aus dem zweiten Satz beruht.

6. Verfahren nach Anspruch 5, wobei die Abweichung eine absolute Abweichung $MES^{abs}$ ist, die gemäß einer Formel des folgenden Typs definiert wird:

$$MES^{abs} = max_{n \in N}\left(\left|\varphi_n^g - \varphi_n^b\right|\right),$$

wobei $\varphi_n^b$ (bzw. $\varphi_n^g$) der durch den Beckensimulator (bzw. den geomechanischen Simulator) bestimmten Porosität in einer Masche n der Maschendarstellung, die N Maschen beinhaltet, entspricht.

7. Verfahren nach Anspruch 5, wobei die Abweichung eine relative Abweichung $MES^{rel}$ ist, die gemäß einer Formel des folgenden Typs definiert wird:

$$MES^{rel} = \frac{2 \times max_{n \in N}\left(\left|\varphi_{n,}^g - \varphi_{n,}^b\right|\right)}{\varphi_n^g - \varphi_n^b},$$

(wobei $\varphi_n^b$ (bzw. $\varphi_n^g$) der durch den Beckensimulator (bzw. den geomechanischen Simulator) bestimmten Porosität in einer Masche n der Maschendarstellung, die N Maschen beinhaltet, entspricht.

8. Verfahren nach einem der vorhergehenden Ansprüche, wobei das Verfahren einen Schritt des Simulierens der Erosion mindestens einer der Schichten und oder des Simulierens einer geologischen Lücke beinhaltet.

9. Computerprogrammprodukt, das aus einem Kommunikationsnetzwerk heruntergeladen werden kann und/oder auf einem computerlesbaren Medium aufgezeichnet ist und/oder von einem Prozessor ausgeführt werden kann, das Programmcodeanweisungen zur Umsetzung des Verfahrens nach einem der vorhergehenden Ansprüche beinhaltet, wenn das Programm auf einem Computer ausgeführt wird.

**Claims**

1. Method for exploiting a sedimentary basin featuring hydrocarbons, comprising a reconstruction of the formation of said basin, said formation comprising at least the deposition of two sedimentary layers, said reconstruction being produced by means of a basin simulator and of a geomechanical simulator cooperating with one another, by means of measurements of properties relating to said basin and of mesh representations representative of said basin at the time of deposition of each of said sedimentary layers, and in which, on the basis of said measurements and of a reconstruction of said formation of the first of said layers, said reconstruction for at least one of said layers overlying said first layer is implemented according to at least the following step:

   A. by means of said basin simulator, a joint basin simulation of said layer and of at least one layer underlying said layer is produced, and a first set of parameters is determined;
   said method being **characterized in that** said reconstruction for at least said of said layers overlying said first layer further comprises the following steps:
   B. on the basis of at least a portion of said first set of said parameters and of said geomechanical simulator, a joint geomechanical simulation of said layer and of at least one layer underlying said layer is produced, and a second set of parameters is determined;
   C. a difference between at least a portion of said parameters of said first set and at least a portion of said parameters of said second set is measured, and steps A to C are reiterated by applying a correction to said basin simulation if said difference is greater than a predefined threshold;

   and **in that**, by means of said reconstruction produced for said layers, at least one region of said basin featuring said hydrocarbons is selected, and said basin is exploited according to said region selected.

2. Method according to Claim 1, in which said reconstruction relating to said first layer is produced according to at least the following steps:

   i. by means of said basin simulator, a basin simulation relating to said first layer is produced, and a first set of parameters is determined;
   ii. on the basis of at least a portion of said first set of said parameters and of said geomechanical simulator, a simulation relating to said first layer is produced, and a second set of parameters is determined;

iii. a difference between at least a portion of said parameters of said first set and at least a portion of said parameters of said second set is measured, and steps i) to iii) are reiterated by applying a correction to said basin simulation if said difference is greater than a predefined threshold.

3. Method according to either of the preceding claims, in which said first set of parameters comprises at least the porosity and the pressure in each of the cells of said mesh representation.

4. Method according to Claim 3, in which said second set of parameters comprises at least the porosity in each of the cells of said mesh representation.

5. Method according to either of Claims 3 and 4, in which said difference is based on a measurement of the difference between said porosity from said first set and said porosity from said second set.

6. Method according to Claim 5, in which said difference is an absolute difference $MES^{abs}$ defined according to a formula of the type:

$$MES^{abs} \;=\; max_{n \in N}\left(\left|\varphi_n^g - \varphi_n^b\right|\right) \quad ,$$

where $\varphi_n^b$ (or $\varphi_n^g$) corresponds to said porosity determined by said basin simulator (or by said geomechanical simulator) in a cell n of said mesh representation comprising N cells.

7. Method according to Claim 5, in which said difference is a relative difference $MES^{rel}$ defined according to a formula of the type:

$$MES^{rel} \;=\; \frac{2 \times max_{n \in N}\left(\left|\varphi_{n,}^g - \varphi_{n,}^b\right|\right)}{\varphi_n^g + \varphi_n^b} \quad ,$$

where $\varphi_n^b$ (or $\varphi_n^g$) corresponds to said porosity determined by said basin simulator (or by said geomechanical simulator) in a cell n of said mesh representation comprising N cells.

8. Method according to one of the preceding claims, in which said method comprises a step of simulating the erosion of at least one of said layers and/or of simulating a geological gap.

9. Computer program product that can be downloaded from a communication network and/or stored on a medium that can be read by a computer and/or can be executed by a processor, comprising program code instructions for implementing the method according to one of the preceding claims, when said program is run on a computer.

a

e

d

b

c

**Figure 1**

**Figure 2**

**Figure 3**

Figure 4

Figure 5

**RÉFÉRENCES CITÉES DANS LA DESCRIPTION**

**Documents brevets cités dans la description**

- US 2011141851 A1
- US 2009265152 A1
- US 2002120429 A1
- US 8271243 B2
- FR 2930350 A
- US 20090265152 A

**Littérature non-brevet citée dans la description**

- **NAYROLES, B. ; G. TOUZOT ; P. VILLON.** The diffuse approximation. *C. R. Acad. Sci., Paris,* 1991, vol. 313, 293-296
- **SCHEICHL, R. ; MASSON, R. ; WENDEBOURG, J.** Decoupling and Block Preconditioning for Sedimentary Basin Simulations. *Computational Geosciences,* 2003, vol. 7 (4), 295-318
- **SCHNEIDER F.** Modelling multi-phase flow of petroleum at the sedimentary basin scale. *Journal of Geochemical exploration,* 2003, vol. 78-79, 693-696
- **SCHNEIDER, F. ; S. WOLF ; I. FAILLE ; D. POT.** A 3D Basin Model for Hydrocarbon Potential Evaluation : Application to Congo Offshore. *Oil & Gas Science and Technology - Rev. IFP,* vol. 55 (1), 3-13
- **STECKLER, M.S. ; A.B WATTS.** Subsidence of the Atlantic-type continental margin off New York. *Earth Planet. Sci. Lett.,* 1978, vol. 41, 1-13
- **ZOBACK ,M. D.** *Reservoir Geomechanics,* 2010
- **ZIENKIEWICZ, O.C. ; RL TAYLOR ; JZ ZHU.** The Finite Element Method: Its Basis and Fundamentals. 2013